# EUROPEAN PATENT APPLICATION

(11) **EP 0 926 259 A2**
(43) Date of publication of application: **30.06.1999**
(21) Application number: 98124061.7
(22) Date of filing: 17.12.1998
(51) Int. Cl.: C23C 16/44

(54) **Reactor for chemical vapour phase deposition**

(30) Priority: 23.12.1997 IT TO971126
(71) Applicant: CSELT Centro Studi e Laboratori Telecomunicazioni S.p.A., 10148 Turin (IT)
(72) Inventor: Bertone, Daniele, 10146 Torino (IT)
(74) Representative: Riederer Freiherr von Paar zu Schönau, Anton

(57) **Abstract**

A reactor is described where the substrates (W) subjected to the deposition process are maintained in a substantially vertical position and are imparted a relative motion with respect to the nozzles (26) whence the carrier gas that carries the deposition reactants exits. Preferably the reactor presents an altogether cylindrical shape, with the substrates (W) mounted on a carousel structure (7) rotating around a main axis (X8) coinciding with the main axis of the case of the reactor. The diffusion of the carrier gas and of the reactants is effected starting from a head (11) which projects from the vault of the case of the reactor and which extends inside the carousel structure (7) where the substrates (W) are mounted. The head (11) presents a plurality of nozzles (26), uniformly distributed on its periphery, for the release of the carrier gas and of the reactants borne thereby. Preferred application for the deposition of semiconductors starting from metal-organic reactants in vapour phase, in particular for integrated optics applications.

## Description

The present invention relates to reactors for carrying out chemical vapour phase deposition processes, and it was developed with particular attention to its possible application to the deposition of semiconductor compounds by using metal-organic compounds as reactants. Such deposition technique, currently known as MOCVD (acronym of Metal-Organic Chemical Vapour Deposition) or MOVPE (acronym of Metal-Organic Vapour Phase Epitaxy), is employed in different technical fields, and in particular in the manufacture of electronic and optoelectronic devices, specifically in the field of integrated optics. In this field, one of the most common uses provides for the deposition of layers, for instance, of alloys comprising indium, gallium, arsenic, phosphor on substrates, for example, of indium phosphide.

Deposition is accomplished starting from metal-organic compounds, usually comprising trimethyls or triethyls. The deposition process (widely known in the art, and hence not requiring to be specifically described herein) essentially provides for the substrate to be coated to be placed inside a reactor where the substrate itself is heated and exposed to a flow of gas (carrier gas) which transports the metal -organic compound (reactant) in vapour phase. When contacting the heated surface of the substrate, the reactant decomposes; the metal component is deposited on the substrate whilst the organic component is carried away by the flow of carrier gas.

In constructing the reactors for carrying out such deposition processes, it is necessary to take several factors into account.

For example, for the reactor case or bell, especially in reactors where the deposition chamber extends mainly in the horizontal direction, the solution of using a quartz glass case is often adopted, especially when the substrate is to be heated by means of lamps. After a certain number (for instance ten) of deposition operations, it is necessary to clean the inner surface of the bell to eliminate the deposits formed thereon. After such an operation it is necessary to initiate a phase, defined as bell "conditioning", aimed at preventing possible cleaning residues from acting as contaminants in the subsequent deposition processes. The need of frequent cleanings and of subsequent conditionings of the bell results into a considerable inefficiency in the use of the reactor.

In any case, delaying the bell cleaning operation results into the risk that the deposits formed on the wall of the bell, particularly in the areas above the substrate subjected to deposition, may become detached from the case and fall onto the substrate, making the result of the deposition - at least in part - unusable.

This drawback also occurs in reactors where the bell presents a mainly vertical development. In such reactors, where the flow of the reactant is usually from top to bottom, an additional problem arises given by the possible establishment of convective currents especially in the vault of the bell. These currents have a perturbing effect on the flow of the reactant towards the substrates whereon the deposition is accomplished. The need to avoid the occurrence of such phenomena often makes it necessary to modify the parameters of the process by moving them towards sub-optimal conditions with respect to the desired ones.

The object of the present invention is to provide a reactor where the aforesaid drawbacks are substantially eliminated.

According to the present invention, such aim is attained thanks to a reactor for deposition processes having the characteristics recalled specifically in the claims that follow.

The invention shall now be described, purely by way of non limiting example, with reference to the accompanying drawings, wherein:
- Figure 1 shows a section in a vertical median plane of a reactor according to the invention, and
- Figure 2 corresponds to a section according to line II-II of Figure 1.

In the Figures, the reference numeral 1 indicates in its entirety a reactor for carrying out deposition processes. It is typically a reactor employable, for instance, for vapour phase deposition of semiconductor compounds, according to the criteria already recalled in the introductory part of the present description.

The reactor 1 essentially comprises a case 2 destined to define at its interior a deposition chamber where, according to criteria better illustrated farther on, the substrates W destined to be subjected to the deposition process are located.

By way of example those substrates may be indium phosphide substrates W of circular or substantially circular shape (due to the presence of one or more cuts - known as "flats" - which identify certain crystallographic directions), presenting, for instance, a diameter on the order of about 5 cm (typically 2 inches).

The case 2 preferably presents an overall cylindrical shape and comprises two heads 3 made of plastic material which retain in the axial direction a cylindrical body 4 of a material such as quartz glass. As already stated in the description of the prior art, the choice of such a transparent material is preferential in reference to the possible use, as heating source for the substrates W, of lamps such as the lamps 5. These usually are halogen lamps represented, in the example shown, as shaped as bar or tube lamps arranged in a regular crown around the peripheral development of the case 2.

Usually both heads 3 present a substantially C-shaped cross-sectional profile. The heads thus present respective lateral edges 3a able to sealingly enclose the body 4, thanks to the presence of annular gaskets 6, substantially similar to so-called "O-rings", in order to obtain the isolation of the deposition chamber from the external environment.

It will also be appreciated that the case structure described is such as to allow the easy opening of the reactor for the positioning and the removal of the substrates W into and from the deposition chamber.

A carrousel structure 7 (constructed, for instance, of metallic material such as stainless steel) is located within such chamber and is supported at the bottom in central position by a shaft 8 driven in rotation about a respective axis of rotation X8 by a motor 9. The carrousel structure 7 is upwardly open, as it will become apparent hereinafter, so that it is substantially cup-shaped. Usually, the axis X8 corresponds with the main axis of the case or bell of the reactor.

The motor 9, usually positioned outside the reactor, can be for instance an electrical motor with selectively variable speed, able to impart to the carrousel structure 7 a rotation speed about the axis X8 on the order of 60 rpm.

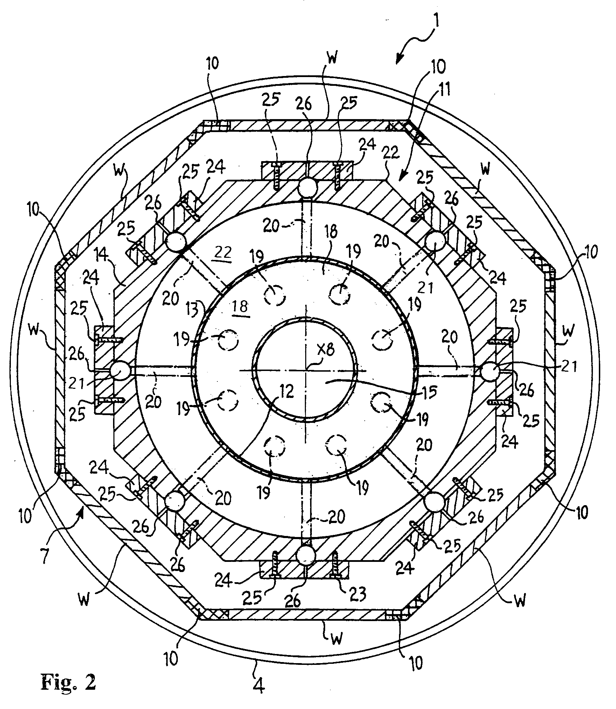

As is better shown in the sectional view of Figure 2, which also comprises some parts seen in plan view, the structure of the carousel 7 can roughly be likened to a sort of polygonal cage having a peripheral or cladding wall with a certain number of faces (eight, in the embodiment shown) each of which can receive or support at least one substrate W arranged vertically.

For mounting the substrate W onto the cladding wall of the carousel structure 7, the solutions currently adopted in the art for mounting substrates inside reactor bells can be adopted.

For example, each face may be equipped with a graphite plate 10 presenting an opening whose profile substantially corresponds to the circumferential profile of the substrates W, thus being able to receive a respective substrate W.

In this way the rear faces (the faces not involved in the deposition process) of the substrates W are oriented towards the outside of the carousel structure 7, hence towards the outside of the body 4, and are therefore still exposed to the heating action provided by the lamps 5.

Conversely, the front faces (again with reference to the deposition process) of the substrates W are oriented towards the interior of the reactor case, thus being exposed to the action of a central body 11 serving as diffusion head for the carrier gas that carries the reactants.

The body 11 is fastened to the head 3 defining the vault of the reactor bell so as to project inside the carousel 7. The body 11 has an approximately cylindrical or prismatic structure and, in the latter case, it has preferably as many faces as the carousel 7.

In particular, the body 11 comprises, in the embodiment shown, three tubular elements or jackets 12, 13 and 14, in mutually coaxial disposition, usually centred with respect to the main axis X8.

The jacket 12 located in central position defines within it a conduit 15 through which a flow of pure carrier gas (typically argon or hydrogen) can be established. The carrier gas is fed through a supply connector 16 and is then conveyed to the outside through one or more exhaust ducts 17. The procedures for feeding/exhausting the gases are wholly conventional.

The presence of the conduit 15 and of the accessory elements associated thereto allows establishing, before starting the deposition process, a regular flow, well stabilised as far its parameters are concerned, of the carrier gas destined subsequently to transport the reactants involved in the deposition process.

Such reactants are instead destined to be fed, for the diffusion towards the substrates W through the chamber 18, with generally annular profile, defined by the second jacket 13 and the outer surface of the jacket 12.

In particular the reactants flow inside the chamber 18 through one or more supply conduits 19.

The embodiment shown provides for the presence of eight conduits of this kind. The correspondence of this number with the number of faces of the body 11 (if it is prismatic) and/or with the number of substrates W treated simultaneously is not to be considered mandatory. The presence of a plurality of supply conduits 19 is dictated primarily by the will to allow simultaneously feeding multiple reactants of different kinds towards the tubular chamber 18 and/or by the will to allow a uniform distribution of the reactants inside the chamber 18, through the supply obtained by means of multiple conduits distributed along the peripheral development of the body 11.

Respective radial conduits 20 (shown here as being positioned in correspondence with the lower part of the annular chamber 18, although that particular disposition is not to be deemed mandatory) branch off from this latter chamber and are destined to let the reactants supplied into the chamber 18 flow towards respective diffusion chambers 21 (see also Figure 2) usually obtained in the outermost jacket 14 of the body 11.

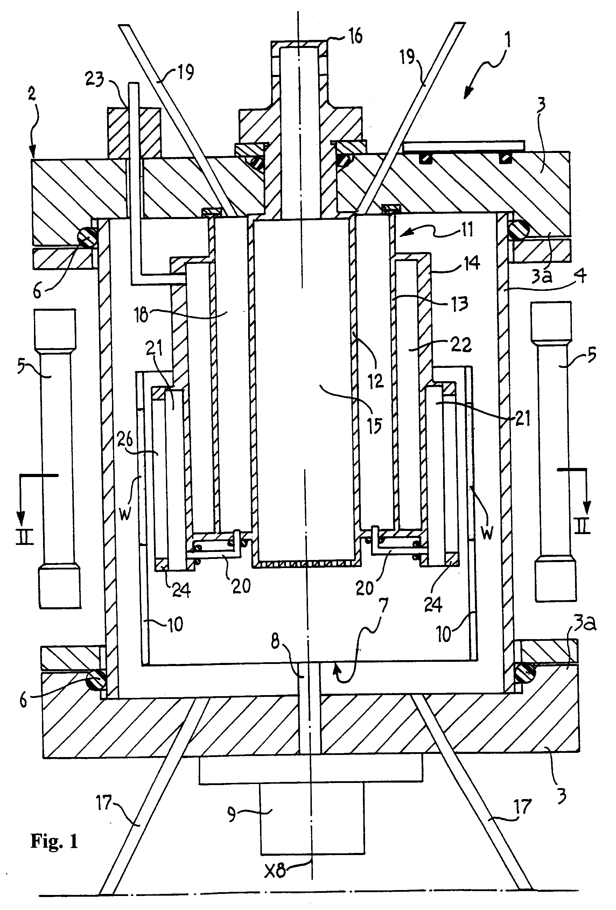

Such outermost jacket 14 defines, with respect to the outer surface of the jacket 13, an additional annular chamber 22 into which a cooling liquid is supplied through at least one conduit 23 (Figure 1). The cooling action is to act so that the outer surface of the body 11 presents a temperature generally lower than the temperature of 600 - 800° C at which the substrates W are heated (in the embodiment shown by means of the lamps 5). In this way the undesired decomposition of the reactants which should in any case reach the surface of the body 11 is avoided, thus avoiding the undesired deposition of material onto the outer surface of the body 11 itself.

The diffusion chambers 21 are shaped, in the embodiment shown, as cylindrical holes having a longitudinal extension (vertical, with respect to the observation point of Figure 1) at least slightly greater than the radial (in particular vertical) extension of the substrates W.

As stated above, such substrates typically present a diameter on the order of about 5 cm (2 inches) and the chambers 21 can present a longitudinal extension typically on the order of 7 cm.

The reference 24 lastly indicates further inserts, usually constructed, like the rest of the body 11, in a metallic material such as steel. The inserts 24 are applied to the outer surface of the body 11 itself so as to delimit externally the chambers 21. In the embodiment shown, the inserts 24 are essentially in the form of roughly rectangular plates destined to be fastened onto the outer wall of the body 11 by means of screws 25. The inserts 24 are pierced (in the vertical direction in the mounted position) by respective slits 26, opening into the respective chambers 21 and having longitudinal dimensions substantially corresponding to those of said chambers; each one of such slits defines a respective flow - and hence diffusion - path, of the reactants that reach such chambers 21 towards the opposite space where the substrates W, mounted on the walls of the carousel structure 7, are located.

As stated above, the reactor is set up for operation by feeding the carrier gas into the central chamber 15. The deposition process is then started, after activating the heating sources (the lamps 5, in the embodiment shown), by switching over the flow of the carrier gas from the central conduit 16 to the conduits 19. Through the latter conduits, the carrier gas conveying the reactants is fed inside the tubular chamber 18. The aforesaid gas flow switching mechanism can be effected in a known manner, such as by using the valve device described in US-A-5.224.513, assigned to the Applicant.

Starting from the tubular chamber 18, through the radial conduits 20, the reactant flows into the chambers 21 to be diffused towards the substrates W through the slits 26.

As an effect of the diffusion through the slits 26, constituting in practice nozzles with rectilinear development, the flow of gaseous substance containing the reactants is diffused in the form of a sort of an altogether uniform linear "beam", destined to impinge against the inner surfaces of the substrates W which rotate around the body 11 as an effect of the activation of the motor 9.

In this way, each substrate W is exposed in sequence to the action of the gas flows outgoing from the various slits 26.

The deposition process can therefore be accomplished in a controlled manner, thereby avoiding the typical drawbacks of the prior art solutions.

In particular, the release of the reactants through the slits 26 causes the reactants themselves to exit into the free deposition room where the substrates W lie, in close proximity to the substrates W themselves. The undesired decomposition of the reactants and the deposition in undesired areas such as the outer surface of the body 11 (subjected to cooling to prevent it from reaching the decomposition temperature) or the inner wall of the central body 4 of the case are minimised.

In consideration of the reduced radial extension of the space between the slit nozzles 26 and the deposition surfaces of the substrates W the possible influence of the convective phenomena which may take place within such space is extremely reduced. Such phenomena as may occur therefore perturb the deposition process only to a minimal extent.

Furthermore, the elongated shape of the nozzles constituted by the slits 26 causes the distribution of the reactant flow over the surface of the individual wafer W to be very uniform.

In practice, the shape of the slits 26 and their relative arrangement with respect to the carousel structure 7 and to the substrates W mounted thereon causes the reactant escaping the slits 26 to scan the deposition surfaces according to a path that is parallel to a diameter of the substantially circular substrates: in other words, the scanning path is initially chordal, then diametral (when the slit is aligned with the centre of the substrate) and then chordal again (when the slit 26 moves away from the centre, progressively moving towards the periphery of the substrate W).

Further, the vertical arrangement of the substrates W causes the latter to be protected against the risks of contamination due to the detachment and fall of deposits formed within the deposition bell. In any case, the deposition process described above cause the accumulation of such residues to be reduced considerably with respect to conventional reactors. This allows increasing the number of deposition cycles that can be completed within the same reactor before having to clean it.

The structure just described is suitable to be adapted according to the particular deposition parameters desired.

For instance, the ease with which the inserts 24 can be removed allows a certain kind of insert to be replaced with another one, if the need arises. It could be for example another insert 24 having, for instance, a slit 26 of different, greater or smaller, length or possibly a different nozzle profile, thereby obtaining - if so desired - a particular distribution of the reactant flow diffused towards the substrate W. The possibility of letting the rotation speed of the motor 9 vary also allows - if it is deemed useful or advantageous - to vary the displacement speed of the substrates W and hence the duration of the time interval over which each substrate W is exposed to the action of the individual slit nozzle 26.

Of course, while the principle of the invention remains unchanged, construction details and embodiments may be varied widely with respect to what is described and illustrated herein, without thereby departing from the scope of the present invention. The number of possible variations includes the variations mentioned below (without, however, being limited thereto):
- the use, in order to achieve substrate heating, of other sources than the lamps shown in the accompanying drawings,
- the possibility of having a different number of nozzles from the number of substrates W mounted on the carousel structure; the solution illustrated in the accompanying drawings, which show eight slits and eight faces of the carousel structure, each bearing a substrate, presents the advantage that all the substrates are subjected to the action of a respective nozzle at the same time: nonetheless, both the number of nozzles and the number of substrates W that can be treated simultaneously thanks to the provision for respective mounting means on the carousel structure may vary at will, such number including in particular a single nozzle/wafer,
- the possibility of configuring the reactant diffusion head, represented in the embodiment shown by the body 11, with distinct supply volumes for different reactants, in order different substrates present in the reactor can be simultaneously subjected to deposition processes involving different reactants and hence different deposited materials, and
- the possibility of replacing one or more of the parts of the reactor shown in the accompanying drawing with functionally equivalent parts: this applies particularly in regard to the construction of the case, which may for instance be made of different metallic material or with different shapes, in particular as a function of the heating means adopted.

## Claims

1. Reactor for deposition processes, comprising a support (7) intended to bear at least one substrate (W) with a face onto which a decomposition product of a vapour phase reactant is to be deposited, as well as means (11) for distributing said reactant, characterised in that:
- said support (7) is arranged to maintain said substrate (W) with said face oriented in a substantially vertical direction,
- said means (11) for distributing the reactant present at least one delivery nozzle (26) for said reactant located in substantial proximity of the face of said substrate (W) mounted on said support (7), and
- driving means (9) are provided to cause the relative motion of said face of said substrate (W) mounted on said support (7) and of said at least one delivery nozzle (26) in said means (11) for distributing the reactant, so that said reactant scans said face.

2. Reactor as claimed in claim 1, characterised in that said support (7) presents a general carousel structure rotatable around a respective rotation axis (X8).

3. Reactor as claimed in claim 2, characterised in that said support (7) and said means (11) for distributing the reactant are located in a case (2) of the reactor presenting essentially cylindrical shape, and in that the rotation axis (X8) of said support substantially coincides with the main axis of said case (2).

4. Reactor as claimed in any of the previous claims, characterised in that said support (7) presents a general cup-like shape and in that said means (11) for distributing the reactant extend, at least in part, inside said support (7).

5. Reactor as claimed in any of the previous claims, characterised in that said support presents a cladding wall presenting at least one seat for mounting at least one respective substrate (W) whereon the deposition is to be effected.

6. Reactor as claimed in claim 5, characterised in that said cladding wall presents an overall prismatic development with a plurality of faces, each presenting at least one respective seat for mounting a respective substrate (W).

7. Reactor as claimed in any of the previous claims, characterised in that said support (7) is made of metallic material.

8. Reactor as claimed in any of the previous claims, characterised in that said support (7) is provided, at least in correspondence with the mounting position of the or each said substrate (W), with a coating insert (10) of graphite.

9. Reactor as claimed in any of the previous claims, characterised in that:
- the reactor presents at least one case part (4) made of a material that is transparent to a heating radiation,
- said support (7) presents at least one seat for mounting said substrate (W) exposed to said reactor case part, and
- means (5) generating a heating electromagnetic radiation are provided, located outside the case of the reactor (2) in correspondence with said case part (4).

10. Reactor as claimed in claim 9, characterised in that said case part is made of quartz glass.

11. Reactor as claimed in claim 3 and in claim 9 or 10, characterised in that said case part (4) constitutes the peripheral wall of said case of substantially cylindrical shape.

12. Reactor as claimed in claim 6 or claim 11, characterised in that said case comprises two substantially disc-shaped head parts (3) in a sealed connection (6) with the peripheral wall (4) of said case.

13. Reactor as claimed in any of the previous claims, characterised in that said at least one delivery nozzle (26) is defined by an opening of elongated shape.

14. Reactor as claimed in claim 13, for the treatment of substrates (W) of substantially circular shape, characterised in that said support (7) and said at least one delivery nozzle (26) of elongated shape are mutually arranged in such a way that, as an effect of said relative motion, said at least one delivery nozzle (26) scans said substrate (W) according to a scanning pattern that is chordal and diametral in a parallel manner.

15. Reactor as claimed in any of the previous claims, characterised in that it comprises at least one insert (24) applied on an outer wall of said means (11) for distributing the reactant and defining said at least one delivery nozzle (26).

16. Reactor according to claim 15, characterised in that said insert (24) is removably (25) mounted on said means (11) for distributing the reactant.

17. Reactor as claimed in any of the previous claims, characterised in that said means (11) for distributing the reactant present a plurality of nozzles (26) for delivering the reactant.

18. Reactor as claimed in claim 6 and in claim 17, characterised in that the number of delivery nozzles (26) present on said means (11) for distributing the reactant corresponds to the number of faces (10) of said cladding wall of the support (7).

19. Reactor as claimed in claim 18, characterised in that both said cladding wall and said means (11) for distributing the reactant are of prismatic shape, with the same number of faces.

20. Reactor as claimed in any of the previous claims, characterised in that said means (11) for distributing the reactant are associated with refrigerating means (22, 23) to maintain the means (11) for distributing the reactant, at least in correspondence with said at least one delivery nozzle, at a temperature lower than the temperature of decomposition of said reactant.

21. Reactor as claimed in any of the previous claims, characterised in that said means (11) for distributing the reactant comprise a plurality of tubular bodies (12, 13, 14) inserted one into the other thereby mutually to define respective flow chambers (15, 18, 22).

22. Reactor as claimed in claim 20 and claim 21, characterised in that one (22) of said flow chambers, generally external with respect to said means (11) for distributing the reactant, is a flow chamber for a refrigerating fluid.

23. Reactor as claimed in claim 21 or 22, characterised in that one (18) of said flow chambers is a chamber for the inflow of said reactant and is associated with at least one conduit (20) for transferring said reactant towards said at least one delivery nozzle (26).

24. Reactor as claimed in claim 23, characterised in that a plurality of delivery nozzles (26) is provided and that said inflow chamber (18) is associated with a conduit (20) for each of the delivery nozzles (26).

25. Reactor as claimed in claims 23 or 24 if referred to claims 22, characterised in that said chamber (18) for the inflow of the reactant is arranged in a generically internal position with respect to said flow chamber (22) for a refrigerating fluid.

26. Reactor as claimed any of claims 21 to 25, characterised in that said means (11) for distributing the reactant comprise a first (15) and a second (18) flow chamber usable respectively to establish a flow of carrier gas for said reactant and for the subsequent diffusion of said reactant borne by said carrier gas.

27. Reactor as claimed in claim 26, characterised in that said second chamber (18) encompasses said first chamber (15).

28. Reactor as claimed in any of the previous claims, characterised in that said driving means (9) are of the type with selectively variable velocity in order selectively to vary the velocity of said relative motion.
